# EUROPEAN PATENT APPLICATION

(11) **EP 1 306 679 A1**
(43) Date of publication of application: **02.05.2003**
(21) Application number: 01204103.4
(22) Date of filing: 29.10.2001
(51) Int. Cl.: G01R 19/25, H01L 21/66

(54) **Method and apparatus for remotely testing semiconductors**

(71) Applicant: Schlumberger Technologies, Inc., San Jose, California 95134-2302 (US)
(72) Inventor: Crist, Fredrick W., Nashua, NH 03062 (US); Wagner, Timothy J., Prunedale, CA 93907 (US)
(74) Representative: Weihs, Bruno

(57) **Abstract**

An apparatus is disclosed for remotely monitoring and developing steps in a semiconductor manufacturing process that includes, at least one remote workstation connected via a remote access link to a local workstation, and a test system connected via a link to the local workstation. A method is also disclosed that includes running a semiconductor test system remotely, monitoring the semiconductor test system remotely, and receiving data from the semiconductor test system remotely. Another embodiment includes an apparatus for remotely monitoring and developing steps in a semiconductor manufacturing process. This embodiment includes a plurality of remote workstations each connected via a remote access link to a local workstation, and a test system connected via a link to a local workstation. Security features in this embodiment prevent any one remote workstation from accessing any other remote workstation.

## Description

### BACKGROUND OF THE INVENTION

### Field of the Invention

The invention relates generally to the field of integrated circuit design and manufacturing. More specifically, the invention relates to systems for testing integrated circuit designs and chips from a location remote from physical testing equipment.

### Description of the Related Art

Because of increasing complexity of newly developed integrated circuits, new types of integrated circuit manufacturing techniques have been developed. Currently, integrated circuit manufacturers commonly use one of several possible approaches to make their products. First, a manufacturer can build and run its own factories to make the semiconductors themselves from already tested circuit designs. These factories are known as silicon foundries or fabrication plants. Some companies only operate such fabrication plants, leaving other steps in the development of new integrated circuits to others. Companies that only operate such foundries are typically referred to as "high volume manufacturers" (HVMs). A number of large companies, known as "integrated device manufacturers" (IDMs) have both the ability to design and test new semiconductors, and also own their own fabrication plants. Alternatively, a company can restrict itself to designing integrated circuits that ultimately are then produced by another, typically one of the HVMs. Traditionally, it was common for a manufacturer to be an IDM. A number of fabrication plants, or "fabs", were built by such IDMs. In order to save capital and operating expenses, the owners of "fabs" sometimes built plants in lower-cost countries. Typically, however, the "fabs" themselves possessed very little capability for semiconductor design. As a result, some companies have begun to appear whose sole concern is to design semiconductor chips. These design companies, which may have no manufacturing or testing capability, typically contract out the testing and production of integrated circuit designs to others. Contracting the manufacturing is generally done with fabrication plants owned by HVMs. Many smaller companies often have no capabilities beyond the initial design of integrated circuits. All the intermediate steps between initial design and production are contracted out to third parties. These design-only companies are referred to as "fabless" firms. Fabless firms generally have a need for testing services to be provided by third parties. However, the fabless firm also has a need to remain closely involved with testing steps that take place prior to "hand off" of the circuit design to the HVM due to the fact that the circuit design may undergo a number of changes during the development process.

There are many intermediate steps between the conceptual development and the actual high volume production of a new integrated circuit. The first step in bringing a new design to the production stage is the initial design. In the initial design, a design engineer, using an end user's specifications, develops a series of logical gates that the design engineer believes will produce the end user's specified functionality in a completed integrated circuit. At this stage, the design engineer produces only an arrangement of logical elements, and typically does not physically construct any device.

The next step is testing the initial design to determine if the integrated circuit will produce the user's specified functionality. At this stage, the testing generally involves simulating the arrangement of logic gates on a computer, and determining the actual functionality of the logic gates so arranged. Changes to the arrangement of logic gates can be performed on the simulation computer to rectify any deficiency in producing the user's specified functionality. The testing and design is then repeated until the logical design meets the user's desired specifications. This re-testing and re-designing cycle is known as debugging. Debugging typically only includes rearranging the simulated or theoretical gates to produce the desired functionality. The testing, at this stage, is typically not rigorous and serves only to confirm that the logic gates are arranged in a proper fashion.

The next step of the integrated circuit development process is fabricating at least one prototype device, this being referred to in the art as "first silicon". This prototype device is then tested, typically more rigorously than the simulated device, in a next step known as design debug. Because of the difficulties in reproducing a theoretical series of logic gates in three-dimensions on a silicon wafer, errors commonly arise in making first silicon. For example, a certain gate might be an AND gate when it needed to be an OR gate. Therefore, the next step in the development process is to debug and repair the first silicon. In order to repair the first silicon device, the individual gates are evaluated and repaired as necessary to produce the end user's functionality in the first silicon device. The gates in the first silicon device are physically observed and/or repaired, by using instruments such as a "focused ion beam" (FIB) probe system, an "electron beam" (e-beam) probe system or an "infrared laser" (Optical) probe system. One such e-beam machine is known by model number IDS 10000_{da}. One such focused ion beam probe system is known by model number IDS P3X. One such infrared laser probe system is known by model number IDS 2000. All of the preceding instruments are sold by Schlumberger Semiconductor Solutions, San Jose, CA. To repair a gate that is inoperative or not working as planned, the FIB or e-beam machine can literally "burn" a hole into the prototype device, cutting a wire to the inoperative gate. After the inoperative gate is disconnected, a new element, such as a jumper, can be put in its place by the FIB probe system. After all the repairs have been made, the prototype device is re-tested until the logical elements produce the end user's desired functionality.

The next step in the process is characterization of the first silicon device. The characterization step generally includes a full-scale performance test of the device sometimes at speeds greater than actually required to meet end user specifications. The performance test includes, for example, a determination of the actual maximum operating speed, the voltages at inputs and outputs, temperature limitations, the results obtained when spurious input data are applied to the device. If the prototype device passes the characterization test, mask work is then made to generate a template to "hand off" to foundry or the HVM. Once the mask work is delivered to the HVM, test protocols must be designed to test the product produced by the HVM. Because every circuit design has different user specifications and different internal logical elements, new test protocols must be designed for each design of device produced. The typical fabless may specify the test protocols, or the fabless may leave the design and implementation of the test protocols, either during design and debug, debug and repair, or high volume manufacturing testing to an outside company.

"Test houses" exist in the industry whose sole functions are to design test equipment and/or to carry out the actual testing at the various stages of circuit development. Some HVM's will carry out the physical testing but will not design the test equipment (which may include software, test interfaces, etc.) or protocols, relying instead on the test house or other entity to design such equipment and protocols. The testing is carried out for the duration of the production cycle of any particular circuit design. At this point, an integrated circuit is generally ready to be sold to end users.

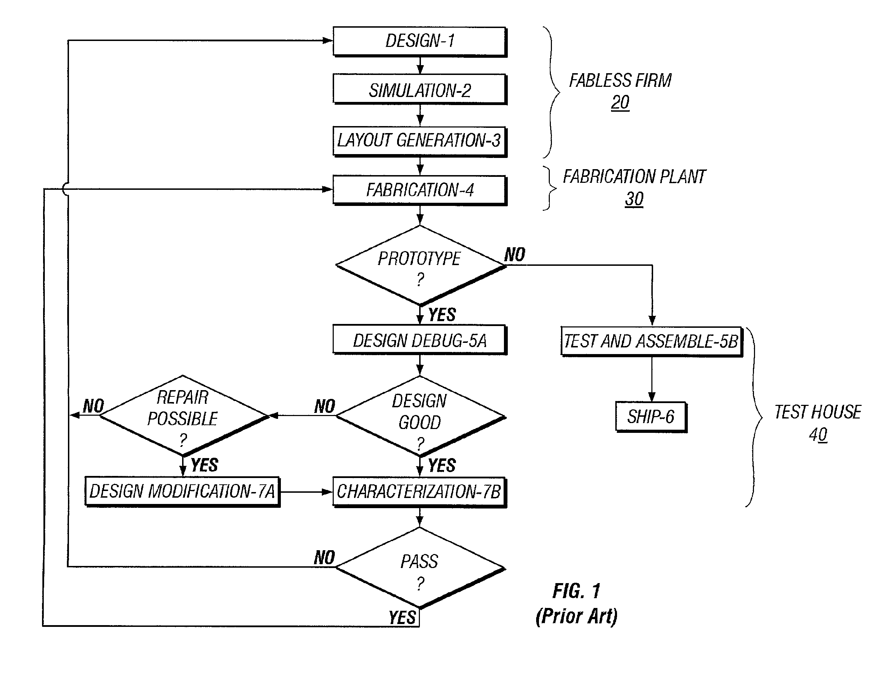

FIG. 1 shows a typical method that a fabless firm, for example, uses to develop a new integrated circuit from an initial design to an end product. A fabless firm **20** first designs the logical arrangement of circuit elements in a proposed integrated circuit chip **10**. The fabless firm **20** may send the initial design for simulation **22** by a third party entity to determine whether the chip **10** functions as intended. The results of the simulation **22** are then sent back to the fabless firm for evaluation. Any changes to the design determined to be necessary during simulation **22** are included in the design at this time. Next, the fabless firm **20** will send the simulation-tested design to a prototype manufacturer **23** to generate a prototype (the previously described "first silicon"). The prototype manufacturer **23** may itself then either test and characterize the prototype **11** or may send the prototype **11** out for testing to a test house **26**. Based on test results obtained by the test house **26** or the prototype manufacturer **23,** the prototype **11** must be fixed/debugged or a new prototype **11** created. After determining that the prototype **11** functions as intended, the debugged prototype **11** is sent to generate a mask **24.** After the mask **24** is generated, the mask **24** is generally sent to a HVM **91**. At this stage, large scale production of the semiconductor chip **10** can begin. Testing of the product made by the HVM **91** may be performed by the test house **26**, and the results of those tests are communicated to the fabless manufacturer **20** and the HVM **91** to remedy any design and/or production flaws found during volume manufacture.

Because of all of the steps involved in bringing a new integrated circuit design to market, *i*.*e*., design step, repair/debug steps, testing step, producing a new semiconductor is difficult and expensive. Monitoring the development of the semiconductor throughout the various stages is also a difficult task, particularly for the fabless firm who must generally contract testing to third parties.

Monitoring involves reviewing and analyzing test results and test data as they become available. For example, a fabless firm would be interested in viewing the test results on semiconductor performance to determine if any design changes are needed, and the effect of any such design changes. Because monitoring is difficult, preventable errors in design, assembly, or other stages may not be avoided. Additionally, a fabless firm may wish to run a testing programs itself to speed up the review of test data, but may not have the required resources. In such a case, a fabless firm may be forced to either outsource the testing or to use the facilities of a test house.

### SUMMARY OF THE INVENTION

In one aspect the invention relates to an apparatus for remotely monitoring and developing steps in a semiconductor manufacturing process. The apparatus according to this aspect of the invention includes at least one remote workstation connected via a remote access link to a local workstation, and a test system connected via a link to the local workstation.

In another aspect, the invention relates to a method for remotely monitoring and developing steps in semiconductor manufacturing. The method according to this aspect of the invention includes running a semiconductor test system remotely, monitoring the semiconductor test system remotely, and receiving data from the semiconductor test system remotely.

In another aspect, the invention relates to an apparatus for remotely monitoring and developing steps in a semiconductor manufacturing process that includes a plurality of remote workstations each connected via a remote access link to a local workstation, and a test system connected via a link to a local workstation

Other aspects and advantages of the invention will be apparent from the following description and the appended claims.

### BRIEF DESCRIPTION OF THE DRAWINGS

FIG. 1 is a prior art illustration of the steps in semiconductor manufacturing.
FIG. 2 is an overview of an embodiment of the invention.
FIG. 3 is an overview of an embodiment of the invention.

### DETAILED DESCRIPTION

In order to speed development and reduce cost in semiconductor manufacturing, companies such as fabless firms may desire the ability to remotely monitor (such as at their own physical facilities), analyze, and run integrated circuit test programs during the design, testing and production phases of making a new integrated circuit.

A test system is generally provided by a "host" that controls (i.e. owns or leases) equipment required for the test system. The host may be an entity known in the art as a "test house", or may be one a part of an integrated device manufacturer that offers testing services to others, these others including, for example, fabless firms. The test system may be any machine or machines and any associated ancillary equipment used in semiconductor circuit testing. For example, one such testing machine is sold under model number ITS 9000KX, by Schlumberger Semiconductor Solutions, San Jose, CA. This test machine advantageously has a high throughput, and maintains a high level of accuracy, so that a large number of semiconductor circuits may be tested quickly. Ancillary equipment may include, for example, a wafer prober, a device handler, or a temperature forcing unit. Additionally, the test system comprises computer hardware and software that run the test machine. The types of computer hardware, software, and test systems available in semiconductor testing are known in the art, and are not intended to limit the scope of the invention. A "client" is an entity wishing to use the host test system. Exemplary clients are fabless firms or HVM's (which may not desire to do their own testing). The term "host network" is used to describe a local computer (intranet) network, or LAN, of the host. Similarly, the term "client network" is used to describe a local computer (intranet) network, or LAN, of the client. The present invention allows a client to monitor, and/or perform directly, testing on a semiconductor design where the test machine is located in a separate physical facility. Typically, but not exclusively, the test machine will be located at the host's physical facility.

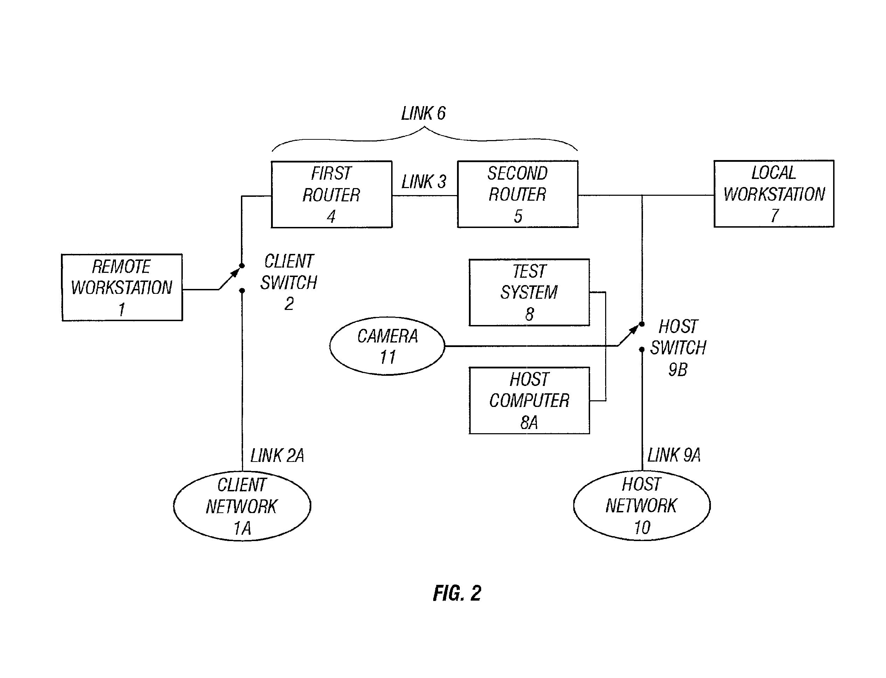

FIG. 2 provides a specific example of one embodiment of the invention. FIG. 2 illustrates the development of a test program which may be used on the previously described ITS 9000 test system **8**. In this example, a remote workstation **1** is installed at a client location. The remote workstation **1** typically will have software thereon required in order for the client to develop a test program for the device under test (DUT). The system of this embodiment of the invention may include a client switch **2,** which is controlled by the client. The client switch **2** enables the client to connect the remote workstation **1**, via a link **2A,** to a client network **1A.** The client switch **2** can connect the remote workstation **1** to the client network **1A,** via a link **2A,** or the client switch **2** can alternatively connect the remote workstation **1** to a first router **4.** The client, in some instances, may wish to connect the remote workstation **1** to the client network **1A** to facilitate transfer of a test program resident on other computers (not shown) at the client's physical facility, to the remote workstation **1.** The nature of the client switch **2** is not intended to limit the scope of the invention, and, moreover, the client may decide whether such a switch is desirable.

The first router **4** connects the remote workstation **1**, via a link **3**, to a second router **5**. The first router **4**, second router **5** and the link **3** comprise a "remote access link" **6** which ultimately links the remote workstation **1** to a local workstation **7**. In this embodiment, the first router **4** and the second router **5** are ISDN routers, sold under Model number 776, by Cisco Systems Inc., of San Jose, CA. Two routers are shown in this embodiment, but one router is sufficient, or more than two routers may be present. The link **3**, connecting the first router **4** and the second router **5** is an ISDN dial-up link, in this embodiment. However, the remote access link **6** can be made up of other components, such as an internet link using a virtual private network. The virtual private network enables information to be sent from one network to another, while maintaining security by encrypting the information. In such a case the information is sent using TCP/IP rather than ISDN protocol. The remote access link **6** may also be one of a variety of links known in the art, such as a T1 telephone line. The remote access link **6** functions like a wide area network (WAN) communication line, and, thus, the remote access link **6** can comprise any WAN technology such as Asynchronous Transfer Mode (ATM), T3, or Frame Relay technologies. When economy is a driving factor, standard modem links may also be used for link **6**. While slow for transferring large amounts of data, a modem link would enable a client to operate the test system **8** remotely. The remote workstation **1** and the local workstation **7** in this embodiment are UNIX-based workstations sold under the model name "Ultra 5", by Sun Microsystems, Inc., of Palo Alto, CA.

The test program must at some point in time be transferred to the local workstation **7** in order to run the test system **8** from the local workstation **7.** In this embodiment, the local workstation **7** is connected to the host's network **10** (LAN), as is the test system **8**. The local workstation **7** is desirable because of the large quantity of data that must be transferred to and from the test system **8**. However, in theory, the remote workstation 1 could be operatively connected to the test system **8** (such as by link **6**) without using the local workstation **7**, if appropriate controls were put in place, i.e. security systems. The test system **8** may be connected to the host network **10** via a link **9A**. The link **9A**, however, is not a direct link, in order to prevent a client from accessing the host network **10** through the local workstation **7**. Instead, a host switch **9B** may be provided, that the host can operate. The host switch **9B** allows the host to access the test system **8** as needed, without the client having access to the host network **10**. The host switch **9B** may be a physical switch, or may be a computer switch operating security software such as is commercially available under the trade name Schlumberger Connectivity Center by OMNES, Schlumberger Ltd., Houston, TX. When using the security software, the host network **10** functions as a virtual private network. In such a case, a plurality of clients will have information stored on a single local workstation **7**, but will be prevented by firewalls from accessing any information other than their own. Alternatively, the host switch **9B** may be a computer controlled switch such as an ethernet switch. The type of switch used is not intended to limit the scope of the invention. When the host selectively operates the host switch **9B**, to connect the test system **8** to the host network **10**, the client is prevented from accessing the local workstation **7** or the test system **8**. However, the host may access both the local workstation **7** and the test system **8** as needed. The host may re-enable the client to remotely access the local workstation **7** and the test system **8**, by selectively operating the host switch **9B.**

After the test program is transferred to the local workstation **7** via the remote access link **6**, the local workstation **7** contains the test program. Transfer of the test program over the remote access link **6** may be time consuming, so it is also possible that the client may wish to transfer the test program onto the local workstation **7** using physical media, such as magnetic tape or a CD-ROM, for example. Once the local workstation **7** contains the test program, the client may arranges for a selected time on the test system **8** to operate and monitor testing of the DUT. When the scheduled time arrives, the host grants access to the test system **8**, generally by selective operation of the host switch **9B.** The test system **8** can then by rebooted from the particular program resident on the local workstation **7**. The client may then access the test system **8** remotely, via the remote access link **6**. Because the remote workstation **1** and the local workstation **7** may be linked, the client can run the local workstation **7** as if the client where physically present at the host's facilities. Additionally, if the client desires, employees of the host may be connected via a host computer **8A** linked to the test system **8**. The host computer **8A** may have software installed such as audio conferencing software, to allow the client to have real-time assistance from host employees while running the test system **8**. In case of an error in the test system **8**, the client can request assistance from the host by issuing a trouble signal. The trouble signal may be sent by conventional means such as over a phone line, or it may be computer generated. The computer generated signal may be sent to the host computer **8A** to alert the host that a problem has occurred. If assistance is required, the host may access via the host computer **8A** or by accessing the local workstation **7**, and provide any technical assistance required. In addition, a networked camera **11** may be linked to the test system **8** so that the client can watch the test system **8** as it functions. The networked camera **11** allows the client to monitor the test system **8** while in operation. Additionally, the host can install ancillary equipment, depending on the clients need. For example, a temperature forcing unit, a wafer prober, and/or a device handler may be added.

Note that during the time when the client is denied access to the test system **8**, the host may operate the test system for his own purposes, such as providing testing services to entities other than the client. In one example, the host may be an IDM who is testing his own circuit designs during periods of time when client access to the test system **8** is denied. In another example, the host may test circuit designs locally for other clients who do not desire remote access to the test system **8**.

The invention is not limited to operation and monitoring of integrated circuit first silicon test programs. For example, a similar system may be used to monitor and develop the design of the semiconductor. In this example, the test system **8** of the previous embodiment is substituted by a probe system as is commonly used to simulate the operation of a proposed circuit design.

In another example, a system similar to the first embodiment of the invention may be used by the HVM to monitor and test the assembled semiconductors.

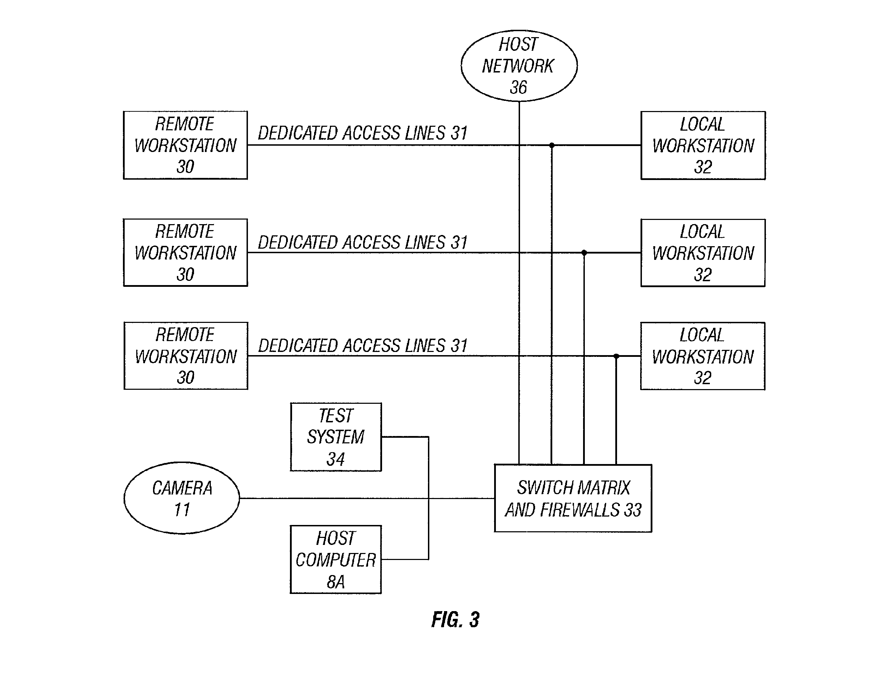

FIG. 3 illustrates an alternative embodiment of the invention, where multiple clients may desire to have remote access and control over a test system. In FIG. 3, rather than each client having its own separate local workstation, a plurality of remote workstations **30** each has a remote access line **3**1. In the example embodiment of FIG. 3, each remote access line is substantially the same as the link (**6** in FIG. 2) in the first embodiment. Each line **31** connects its corresponding one of the remote workstations **30** to a single local workstation **32**. The local workstation **32** is generally in the same physical facility as the test system (as in the first embodiment). The data and test programs for each of the individual clients are typically separated by a series of firewalls **33** in the local workstation **32**. The firewalls **33** create secure enclaves for an individual client's data and test programs. When a particular client has scheduled time on the local workstation **32** (in order to run the test system **34**) all other clients are prevented from accessing the local workstation **32**, ensuring maximum security for the particular client. Additionally, the particular client may only connect to the local workstation **32** after being screened by the host's security system. Any intrusion into test system **34** is immediately recorded and ticketed for further follow up by the host. The host schedules particular times on the test system **34** for particular single clients, who may then operate the test system **34** as described in the first embodiment. A switch **35,** is provided so that a host network **36** may connect or disconnect from the test system **34** as described in the previous embodiment.

Those skilled in the art will appreciate that other embodiments of the invention can be devised which do not depart from the spirit of the invention as disclosed herein. Accordingly, the scope of the invention shall be limited only by the attached claims.

## Claims

1. An apparatus for remotely monitoring and developing steps in a semiconductor manufacturing process comprising:
at least one remote workstation connected via a remote access link to a local workstation;
a test system connected via a link to the local workstation.

2. The apparatus of claim 1, further comprising a client switch that connects a client network to the at least one remote workstation.

3. The apparatus of claim 2, further comprising a host switch that connects a host network to the test system and when engaged, prevents client access to the test system.

4. The apparatus of claim 3, wherein the host switch comprises a manual switch.

5. The apparatus of claim 3, wherein the host switch comprises an ethernet switch.

6. The apparatus of claim 3, wherein the host switch comprises a computer operating security software.

7. The apparatus of claim 1, wherein the remote access link comprises:
a wide area network communication line operatively coupling the local workstation to the remote workstation.

8. The apparatus of claim 7, wherein the remote access link further comprises at least one router.

9. The apparatus of claim 1, wherein the link comprises a Local Area Network including the local workstation and the test system.

10. The apparatus of claim 1, wherein the test system further comprises ancillary equipment pre-selected by a client to test various functions of a device.

11. The apparatus of claim 10, wherein the ancillary equipment further comprises a temperature forcing unit.

12. The apparatus of claim 10, wherein the ancillary equipment further comprises a wafer prober.

13. The apparatus of claim 10, wherein the ancillary equipment further comprises a device handler.

14. An apparatus for remotely monitoring and developing steps in a semiconductor manufacturing process comprising:
a plurality of remote workstations each connected via a remote access link to a local workstation;
a test system connected via a link to the local workstation.

15. The apparatus of claim 14, wherein the local workstation includes a plurality of firewalls adapted to prevent access from one of the remote workstation to any other one of the remote workstations.

16. The apparatus of claim 14, wherein at least one of the remote access links comprises an internet connection.

17. The apparatus of claim 14, wherein at least one of the remote access links comprises a dedicated WAN technology.

18. The apparatus of claim 14, further comprising a host switch adapted to selectively connect a host networking service to the test system.

19. The apparatus of claim 14, wherein the test system further comprises ancillary equipment pre-selected by a client to test various functions of a semiconductor device.

20. The apparatus of claim 19, wherein the ancillary equipment further comprises a temperature forcing unit.

21. The apparatus of claim 19, wherein the ancillary equipment further comprises a wafer prober.

22. The apparatus of claim 19, wherein the ancillary equipment further comprises a device handler.

23. A method for remotely monitoring and developing steps in semiconductor manufacturing comprising:
running a semiconductor test system remotely from a remote workstation coupled over a link to a local workstation, the local workstation being operatively coupled to the test system;
monitoring the semiconductor test system remotely from the remote workstation; and
receiving data from the semiconductor test system at the remote workstation.

24. The method of claim 23, wherein the semiconductor test system comprises a semiconductor probe system for testing semiconductor design validity.

25. The method of claim 23, wherein the semiconductor test system comprises a test system adapted to monitor the functionality of semiconductors produced by a foundry.

26. An apparatus for remotely monitoring and developing steps in a semiconductor manufacturing process comprising:
at least one remote workstation operatively connected via a Wide Area Network communication line to a local workstation;
a test system connected via a Local Area Network to the local workstation; and
a host network detachably connected by a host switch and a link to the test system.

27. The apparatus of claim 26, further comprising a video camera networked to the test system.
